Europäisches Patentamt

European Patent Office

Office européen des brevets

(11) Publication number: **0 383 512**
**A1**

# EUROPEAN PATENT APPLICATION

(21) Application number: 90301450.4

(22) Date of filing: 12.02.90

(51) Int. Cl.5: **H03K 17/96, H03K 17/18**

(30) Priority: 15.02.89 GB 8903411
05.05.89 GB 8910422

(43) Date of publication of application:
22.08.90 Bulletin 90/34

(84) Designated Contracting States:
AT BE CH DE ES FR GB GR IT LI LU NL SE

(71) Applicant: Flowerday, Michael John
24 Kennedy Avenue
Gorleston, Great Yarmouth, Norfolk(GB)

(72) Inventor: Flowerday, Michael John
24 Kennedy Avenue
Gorleston, Great Yarmouth, Norfolk(GB)

(74) Representative: Jones, William
Willow Lane House Willow Lane
Norwich NR2 1EU(GB)

(54) Touch switch and/or electrical indicator devices.

(57) A touch control and/or indicator device is mounted on a control panel (1) using a mounting plate (5) which is attached to the rear of the panel, in alignment with a pattern (2) on the opposed surface, using an adhesive, preferably in the form of double-sided adhesive film or tape (4). The electrical components (10) for the device are then detachably mounted on the plate. In the case of indicator devices, the panel is light-transmitting, the mounting plate or pads being usable as masks, if desired. In another aspect of the invention, a capacitive level probe is constructed in the same manner using a conductive probe adhesively attached to the mounting plate.

EP 0 383 512 A1

## IMPROVEMENTS TO TOUCH SWITCH AND/OR ELECTRICAL INDICATOR DEVICE

Field of the Invention

This invention relates to an electrical indicator and/or control assembly, for example forming part of an operator control panel for machinery or the like, or for the inputting of data, and is especially advantageously applicable to the construction of touch switches.

Conventionally, control panels comprise mechanical switches and lamp or light-emitting diode (LED) displays mounted in apertures in the panel. Where protrusions are undesirable, or where it is necessary to seal off the switching mechanism from the atmosphere, for example because of moisture or flammable gases, membrane switches or capacitive switches are used, and lamps or LEDs are mounted beneath light transmitting portions of the panel.

a problem with membrane switches is that, if a fault occurs in one switch of an array of switches, it is usually necessary to replace the whole array. Capacitive switches are mounted using screws through the panel, or on a backing plate attached to the panel by brackets, and repair usually requires the replacement of the whole switch, or disassembly to repair a printed circuit board forming part of the switch.

Summary of the Invention

The present invention provides an electrical indicator and/or control assembly comprising:

a) a user interaction member at which the user may operate a control device by touching a first surface of said member and/or through which the user may view an indicator device;

b) mounting means adhesively attached to the opposed surface of said member; and

c) operating electrical circuit means for said control device and/or comprising said indicator device, detachably mounted on said mounting means.

In one aspect of the invention, the mounting means includes a pair of electrodes in adhesive contact with said opposed surface, and means for connecting each electrode to the operating electrical circuit means. The connecting means may comprise a pair of plugs upstanding from said surface, and the operating electrical circuit means may comprise a pair of sockets, the sockets being arranged to hold the operating electrical circuit means on the mounting means. Typically, the operating electrical circuit means comprise an electrical circuit board. Two or more electrical circuit boards may be used, one stacked upon the other, one forming, for example, the control circuit board, while the other forms an output circuit board. This allows for greater assembly density, the maximum density being determined by the required operator sensitivity. A single board may be used if the assembly area in the plan of the panel is large enough or if the control board is reduced in size, for example using thick or thin film techniques or customised circuit components. A large variety of output configurations can thereby be achieved inexpensively.

The user interaction member may comprise an electrically conductive probe, for example operating a capacitive switch. In another embodiment of the invention, the user interaction member comprises an electrically non- conductive panel. The panel may include printed or engraved patterns and the mounting means will be secured in a predetermined relationship to said patterns. The panel may be light transmitting, and the operating electrical circuit means may include an indicator device, the output of which is visible through said panel.

Where the user interaction member is a light transmitting panel, and the operating electrical circuit means comprise an indicator device, the mounting means may also serve as a mask for the output of the indicator device. For example, the indicator device may comprise an LED or an array of LEDs. The mounting means may comprise a lens and/or a filter for the indicator device.

The invention also provides a method of mounting an indicator and/or control device on a panel, comprising adhesively securing mounting means to the reverse side of the panel at a predetermined position, and removably mounting the indicator and/or control device on said mounting means.

The invention further provides a capacitive level probe device, comprising a conductive probe attached to a circuit mounting means via a non-conductive adhesive film, the circuit mounting means comprising a pair of electrodes, and electrical circuit means detachably mounted on said mounting means and electrically connected to the electrodes.

The assembly of the invention permits control devices and/or indicator devices to be fastened accurately to a control panel or the like, on the reverse side thereof from the operator, and for the electrical components of said devices to be readily removed and replaced for maintenance purposes.

Brief Description of the Drawings

Reference is made to the drawings, which show preferred embodiments of the invention and in which:

Figure 1 is an exploded perspective view of an indicator and control assembly;

Figure 2 is an exploded perspective view of a capacitive electrical switch using a conductive probe;

Figure 3 is an exploded perspective view of an LED indicator assembly;

Figure 4 is an exploded perspective view of an alternative embodiment to that shown in Figure 3; and

Figure 5 illustrates the mounting of another indicator device.

Description of the Preferred Embodiments

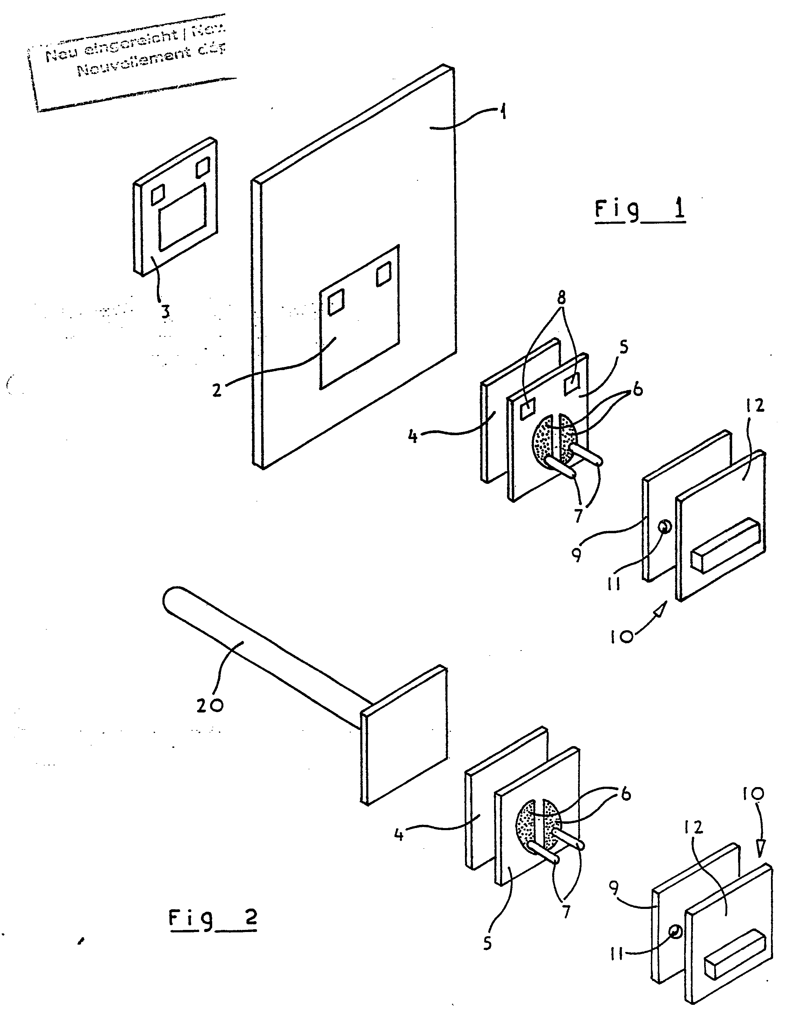

In the assembly illustrated in Figure 1, a portion only of a control panel 1 is shown for the sake of clarity. The control panel 1 is formed of a non-conductive material, for example a plastics material or glass. The panel may have a laminated construction. A pattern 2 is printed or engraved onto the surface of the panel to indicate the location of the control for the operator. For ease in registration of the device, an outline pattern 3 is positioned on the exterior of the panel 1, appropriately aligned with the pattern. A double -sided adhesive film 4, such as a double-sided adhesive tape,is then applied to the reverse of the panel in registration with the outline panel 3 and a touch switch plate 5 is then applied to the film 4 thereby securing the plate 5 to the reverse of the panel 1.

The touch switch plate 5 forms part of a capacitive touch switch and includes two electrodes 6 each having a conductive plug 7 extending outwardly therefrom. Two apertures 8 are also formed in the touch switch plate to allow the passage of light from indicator light-emitting diodes mounted on a control board 9 which forms part of a switch unit 10. The control board 9 has two sockets 11 which receive the plugs 7, thereby permitting the switch unit to be mounted on the touch switch plate 5. The plugs and sockets also serve to make the electrical connections between the electrodes and the switch unit 10. In adverse conditions, the connection may also be soldered. The switch unit 10 includes an output board 12 connected therewith which may be connected by a cable (not shown) to the equipment being controlled by the assembly, for example.

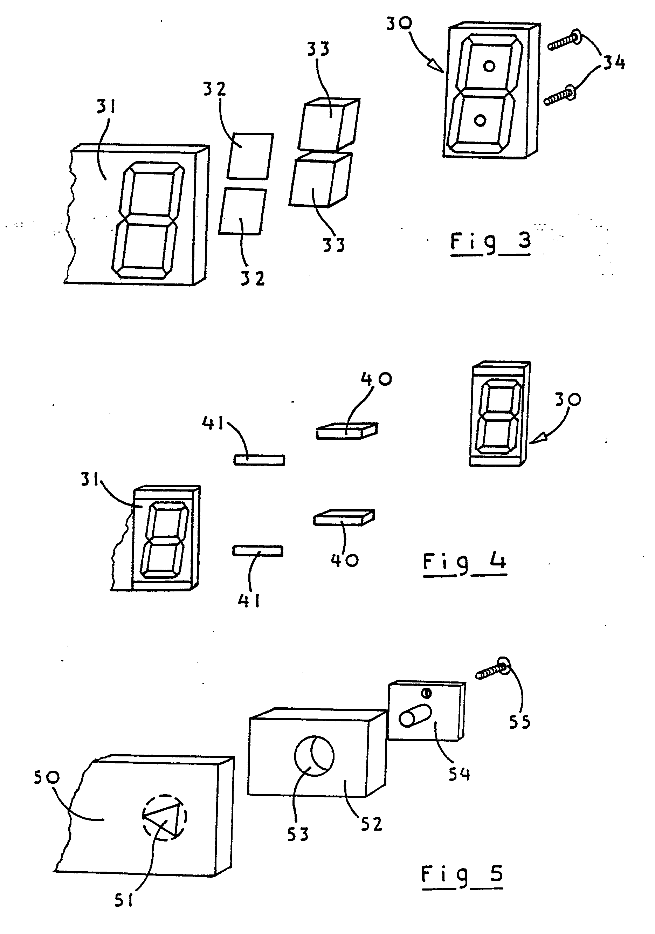

Referring now to Figure 2, to form a capacitive level probe, a conductive probe 20 may replace the panel 1, contact with the probe effecting capacitive switching as before. The other components of the assembly are identical with those shown in Figure 1, with the exception of the omission of the light-emitting diodes, and are identified with the same reference numerals.

Figure 3 shows an LED array in the form of a seven segment numeric display 30, which is attached to the rear face of a transparent control panel 31 using double-sided adhesive film elements 32 to secure registration pads 33 to the rear face of the panel 31 in the appropriate alignment. The LED device is then attached to the registration pads 33 using, for example, screws 34. The registration pads 33 are opaque, thereby preventing light from one segment spreading into the output region of another segment.

Figure 4 shows an alternative assembly in which the registration pads 40 are attached by double-sided adhesive film 41 above and below the seven segment display elements.

Figure 5 shows a method of mounting a single light-emitting diode or lamp light source on a panel 50 having a symbol 51 printed or otherwise formed on its surface and intended to be illuminated by the LED or lamp. A registration pad 52 is fixed to the rear face of the panel 50 by adhesives in such a manner that a hole 53 therethrough is aligned with the symbol 51. An LED or lamp assembly 54 is then attached to the registration pad 52 with the LED or lamp protruding into the hole 53, by means of a screw 55, for example.

The registration pads may be manufactured from metal or non-metallic materials and may be transparent, translucent or opaque. They may also be designed to perform the function of a lens and/or filter for the display or light source. Once the registration pads are optically aligned and attached to the panels, the display or light source may readily be removably attached to them. This arrangement enables the replacement of any particular device without requiring re-registration or attachment to the panel.

Claims

1. An electrical indicator and/or control assembly, comprising:

(a) a user interaction member at which the user may operate a control device by touching a first surface of said member and/or through which the user may view an indicator device;

(b) mounting means adhesively attached to the opposed surface of said member, and

(c) operating electrical circuit means for said control device and/or comprising said indicator device, detachably mounted on said mounting means.

2. An assembly according to Claim 1, wherein the mounting means includes a pair of electrodes in adhesive contact with said opposed surface, and means for connecting each electrode to the operating electrical circuit means.

3. An assembly according to Claim 2, wherein the connecting means comprise a pair of plugs upstanding from said surface, and the operating electrical circuit means comprises a pair of sockets, the sockets being arranged to mount the operating electrical circuit means on the mounting means.

4. An assembly according to any preceding Claim, wherein the user interaction member comprises an electrically conductive probe.

5. An assembly according to any of Claims 1 to 3, wherein the user interaction member comprises an electrically non-conductive panel.

6. An assembly according to Claim 5, wherein the panel is light transmitting, and the operative electrical circuit means includes an indicator device, the output of which is visible through said panel, wherein the mounting means also serve as a mask.

7. An assembly according to Claim 6, wherein the mounting means comprises a lens and/or filter for the indicator device.

8. A method of mounting a control and/or indicator device on a panel, comprising adhesively securing mounting means to the reverse side of the panel at a pre-determined position, and removably mounting the control and/or indicator device on said mounting means.

9. A method according to Claim 8, wherein the mounting means are secured to the reverse side of the panel using double-sided adhesive film.

10. A capacitive level probe device comprising a conductive probe attached to a circuit mounting means via a non-conductive adhesive film, the circuit mounting means comprising a pair of electrodes, and electrical circuit means detachably mounted on said mounting means and electrically connected to the electrodes.

1

Fig_1

8

5

6

4

7

12

9

11

10

20

4

6

7

10

12

9

5

11

Fig_2

_Fig_3_

_Fig_4_

_Fig_5_

## DOCUMENTS CONSIDERED TO BE RELEVANT

EP 90301450.4

| Category | Citation of document with indication, where appropriate, of relevant passages | Relevant to claim | CLASSIFICATION OF THE APPLICATION (Int. Cl.⁵) |
|---|---|---|---|
| A | <u>DE - A1 - 3 123 372</u><br>(IFM)<br> * Totality * | 1-10 | H 03 K 17/96<br>H 03 K 17/18 |
| A | <u>DE - A1 - 3 149 722</u><br>(GLAVERBEL)<br> * Abstract; claims * | 1-7 | |
| A | <u>DE - A1 - 3 411 477</u><br>(CANON)<br> * Totality * | 1,8,10 | |
| A | <u>DE - A1 - 3 512 269</u><br>(T.I.)<br> * Fig. 1,3,4,5; claims * | 1,8,10 | |
| A | <u>GB - A - 2 022 872</u><br>(EURO HAUSGERÄTE)<br> * Totality * | 1-10 | |
| A | <u>GB - A - 2 071 338</u><br>(C.H.INDUSTR.LIMITED)<br> * Totality * | 1-10 | TECHNICAL FIELDS SEARCHED (Int Cl.⁵) |
| A | <u>GB - A - 2 128 336</u><br>(GLAVERBEL)<br> * Abstract; claim 1 * | 1,8,10 | H 03 K 17/00 |
| A | <u>EP - A1 - 0 015 438</u><br>(AGFA-GEVAERT)<br> * Totality * | 1-10 | |
| A | <u>EP - A2/A3 -0 203 261</u><br>(PENNWALT CORP.)<br> * Totality * | 1,8,10 | |

The present search report has been drawn up for all claims

| Place of search | Date of completion of the search | Examiner |
|---|---|---|
| VIENNA | 21-05-1990 | BAUMANN |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82